# EUROPEAN PATENT APPLICATION

(11) **EP 4 826 760 A1**
(43) Date of publication of application: **21.10.2026**
(21) Application number: 26172581.6
(22) Date of filing: 15.04.2026
(51) Int. Cl.: H01J 37/32

(54) **SUBSTRATE PROCESSING APPARATUS, SUBSTRATE PROCESSING METHOD, METHOD OF MANUFACTURING SEMICONDUCTOR DEVICE AND PROGRAM**

(30) Priority: 17.04.2025 JP 2025068409
(71) Applicant: Kokusai Electric Corp., Tokyo 100-0004 (JP)
(72) Inventor: MUROBAYASHI, Masaki, Toyama-shi, 939-2393 (JP)
(74) Representative: Verscht, Thomas Kurt Albert

(57) **Abstract**

It is possible to uniformly distribute a plasma on a substrate being processed in a process chamber. There is provided a technique that includes: a process vessel including: a first plasma generation region where a first gas is supplied to generate a first plasma; and a substrate processing region; a first plasma generator including a first electrode on an outer periphery of the process vessel to generate the first plasma by a first high frequency power; a substrate mounting structure at the process vessel; a second plasma generator including: a second plasma generation region where a second gas is supplied to generate a second plasma; and a second electrode for generating the second plasma by a second high frequency, wherein the second plasma generator supplies the second plasma into the process vessel from beside the process vessel; and a controller for controlling the first and the second plasma generator.

## Description

### [Technical Field]

The present disclosure relates to a substrate processing apparatus, a substrate processing method, a method of manufacturing a semiconductor device and a program.

### [Related Art]

According to some related arts, as an example of a substrate processing apparatus, a semiconductor manufacturing apparatus may be used to manufacture a semiconductor device. In such a substrate processing apparatus, as shown in Patent Document 1, a resonance coil is provided (installed) around an outer periphery of a process vessel where a substrate processing is performed to generate a plasma in the process vessel.

### [Related Art Document]

### [Patent document]

Patent Document 1: Japanese Patent Laid-Open No. 2014-75579.

### [Disclosure]

### [Technical Problem]

According to the present disclosure, there is provided a technique capable of uniformly distributing a plasma on a substrate being processed in a process chamber.

### [Technical Solution]

According to an embodiment of the present disclosure, there is provided a technique that includes: a process vessel provided with: a first plasma generation region where at least one first gas is supplied to generate a first plasma from the at least one first gas; and a substrate processing region where a substrate is plasma-processed; a first plasma generator provided with a first electrode arranged on an outer periphery of the process vessel and configured to generate the first plasma in the first plasma generation region when a first high frequency power is supplied; a mounting structure arranged at a lower portion of the process vessel and configured such that the substrate is placed on the mounting structure; a second plasma generator provided with: a second plasma generation region where a second gas is supplied to generate a second plasma from the second gas; and a second electrode configured to generate the second plasma in the second plasma generation region when a second high frequency power is supplied, wherein the second plasma generator is configured to supply the second plasma into the process vessel from a side surface of the process vessel; and a controller configured to be capable of controlling each of the first plasma generator and the second plasma generator.

### [Advantageous Effects]

According to some embodiments of the present disclosure, it is possible to uniformly distribute a plasma on a substrate being processed in a process chamber.

### [Brief Description of Drawings]

FIG. 1 is a diagram schematically illustrating a configuration of a substrate processing apparatus according to one or more embodiments of the present disclosure.
FIG. 2 is a diagram schematically illustrating a horizontal cross-section of the substrate processing apparatus according to the embodiments of the present disclosure.
FIG. 3 is a block diagram schematically illustrating a configuration of a controller and its related components of the substrate processing apparatus according to the embodiments of the present disclosure.
FIG. 4 is a flow chart schematically illustrating a substrate processing according to the embodiments of the present disclosure.

### [Detailed Description]

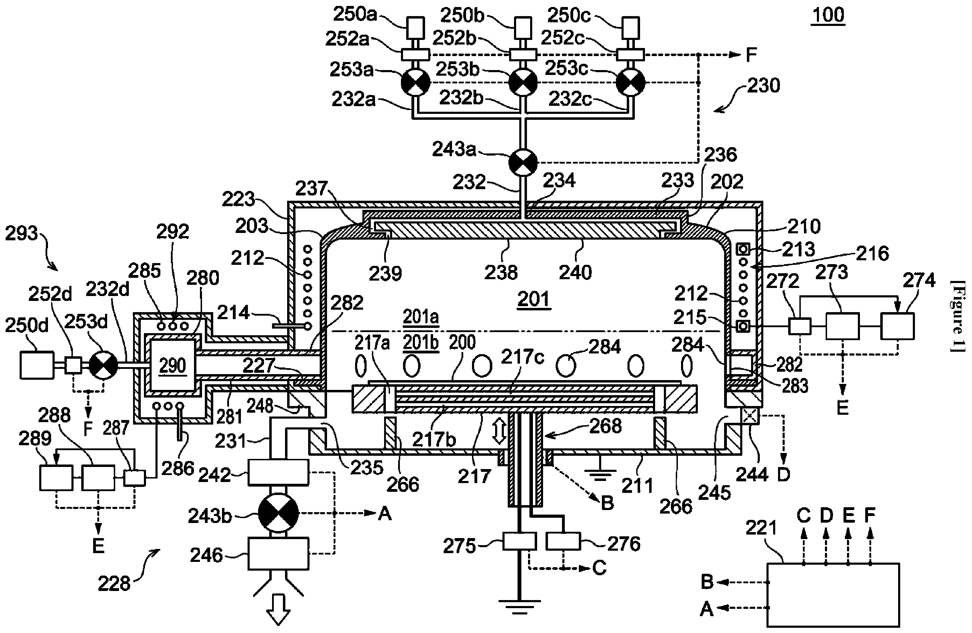

Hereinafter, one or more embodiments (hereinafter, also simply referred to as "embodiments") according to the present disclosure will be described mainly with reference to FIGS. 1 to 3. For example, the drawings used in the following descriptions are all schematic, and a relationship between dimensions of each component and a ratio of each component shown in the drawing may not always match the actual ones. In addition, even between the drawings, the relationship between the dimensions of each component and the ratio of each component may not always match. In addition, the same or similar reference numerals in each drawing represent the same or similar components or structures unless otherwise described related to each drawing.

### (1) Configuration of Substrate Processing Apparatus

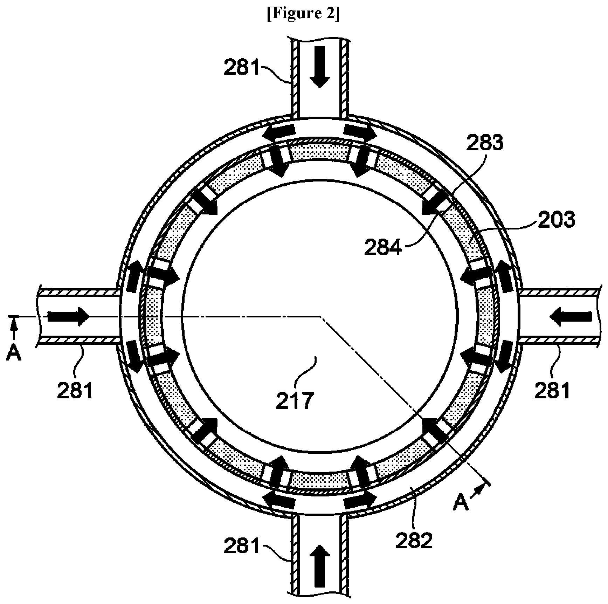

As shown in FIG. 1, a substrate processing apparatus 100 includes a process furnace 202 in which a wafer 200 serving as a substrate is processed by a plasma (that is, the wafer 200 is plasma-processed). In FIG. 1, a cross-section of the substrate processing apparatus 100 taken along a line A - A shown in FIG. 2 is illustrated. The process furnace 202 is provided with a process vessel 203 serving as a vessel constituting a process chamber 201. That is, the substrate processing apparatus 100 is configured to process the wafer 200 by the plasma (that is, to plasma-process the wafer 200) in the process vessel 203. The process vessel 203 is provided with an upper vessel 210 of a dome shape and a lower vessel 211 of a bowl shape. The substrate processing apparatus 100 is further provided with a base plate 248 configured to cover an upper end of the lower vessel 211. A through-hole is provided (or formed) in the base plate 248.

By covering the lower vessel 211 with the upper vessel 210, the process chamber 201 is defined. For example, the upper vessel 210 is made of quartz (SiO₂). For example, the lower vessel 211 is made of aluminum (Al).

In addition, as shown in FIG. 1, a gate valve 244 is provided on a lower side wall of the lower vessel 211. While the gate valve 244 is open, the wafer 200 can be transferred (loaded) into the process chamber 201 through a loading/unloading port 245 using a wafer transfer structure (not shown) or can be transferred (unloaded) out of the process chamber 201 through the loading/unloading port 245 using the wafer transfer structure. While the gate valve 244 is closed, the gate valve 244 functions as a gate valve capable of maintaining the process chamber 201 airtight.

The process chamber 201 may include a first plasma generation region (also referred to as a "first plasma generation area") 201a and a substrate processing region (also referred to as a "substrate processing area") 201b. A first electrode 212 serving as a resonance coil is provided around the first plasma generation region 201a. The substrate processing region 201b communicates with the first plasma generation region 201a, and serves as a region (space) in which the wafer 200 is processed. The first plasma generation region 201a refers to a space in which the plasma (that is, a first plasma) is generated, for example, a space above a lower end of the first electrode 212 and below an upper end of the first electrode 212 in the process chamber 201. In addition, the substrate processing region 201b refers to a space in which the wafer 200 is processed by using the plasma, for example, a space below the lower end of the first electrode 212.

### <Susceptor 217>

As shown in FIG. 1, a susceptor 217 serving as a substrate mounting table on which the wafer 200 is placed is arranged at a center of a lower portion of the process chamber 201.

A heater 217b serving as a heating structure is integrally embedded in the susceptor 217. A heater power regulator 276 is connected to the heater 217b.

The susceptor 217 is electrically insulated from the lower vessel 211. An impedance adjusting electrode 217c is provided in the susceptor 217. The impedance adjusting electrode 217c is grounded via a variable impedance regulator 275 serving as an impedance regulator (which is an impedance adjusting structure).

A susceptor elevator (which is a susceptor elevating structure) 268 including a driver (which is a driving structure: not shown) capable of elevating and lowering the susceptor 217 is provided at the susceptor 217. In addition, through-holes 217a are provided at the susceptor 217, and wafer lift pins 266 are provided at a bottom surface of the lower vessel 211 at locations corresponding to the through-holes 217a. When the susceptor 217 is lowered by the susceptor elevator 268, the wafer lift pins 266 pass through the through-holes 217a without contacting the susceptor 217.

A mounting structure (placement structure) according to the present embodiments is constituted mainly by the susceptor 217 with the heater 217b embedded therein.

### <First Gas supplier 230>

As shown in FIG. 1, a first gas supplier (which is a first gas supply system) 230 serving as a part of a gas supplier (which is a gas supply system) is provided above the process chamber 201. Specifically, a gas supply head 236 is provided above the process chamber 201, that is, on an upper portion of the upper vessel 210. The gas supply head 236 may include a lid 233 of a cap shape, a gas inlet port 234, a buffer chamber 237, an opening 238, a shield plate 240 and a gas outlet port 239, and is configured such that gases are capable of being supplied into the process chamber 201 through the gas supply head 236.

A first gas supply pipe 232 is connected to the gas inlet port 234. A downstream end of a main first gas supply pipe (also referred to as a "primary first gas supply pipe") 232a through which a main first gas (also referred to as a "primary first gas") of a first gas is supplied, a downstream end of a subsidiary first gas supply pipe (also referred to as a "secondary first gas supply pipe") 232b through which a subsidiary first gas (also referred to as a "secondary first gas") of the first gas is supplied and a downstream end of an inert gas supply pipe 232c through which an inert gas is supplied are connected to the first gas supply pipe 232 so as to be conjoined with one another. For example, the first gas includes the main first gas and the subsidiary first gas.

A mass flow controller (MFC) 252a serving as a flow rate controller and a valve 253a serving as an opening/closing valve are sequentially provided at the main first gas supply pipe 232a in this order from an upstream side to a downstream side of the main first gas supply pipe 232a in a gas flow direction. An MFC 252b and a valve 253b are sequentially provided at the subsidiary first gas supply pipe 232b in this order from an upstream side to a downstream side of the subsidiary first gas supply pipe 232b in the gas flow direction. An MFC 252c and a valve 253c are sequentially provided at the inert gas supply pipe 232c in this order from an upstream side to a downstream side of the inert gas supply pipe 232c in the gas flow direction. Although not included in the substrate processing apparatus 100, a main first gas supply source (also referred to as a "primary first gas supply source") 250a is provided at the main first gas supply pipe 232a at an upstream side of the MFC 252a, a subsidiary first gas supply source (also referred to as a "secondary first gas supply source") 250b is provided at the subsidiary first gas supply pipe 232b at an upstream side of the MFC 252b, and an inert gas supply source 250c is provided at the inert gas supply pipe 232c at an upstream side of the MFC 252c.

A valve 243a is provided at the first gas supply pipe 232. The first gas supplier 230 is configured to be capable of supplying the gases (for example, the main first gas and the subsidiary first gas) used for processing the wafer 200 into the process vessel 203.

The first gas supplier (first gas supply system) 230 according to the present embodiments is constituted mainly by the gas supply head 236 (that is, the lid 233, the gas inlet port 234, the buffer chamber 237, the opening 238, the shield plate 240 and the gas outlet port 239), the main first gas supply pipe 232a, the subsidiary first gas supply pipe 232b, the inert gas supply pipe 232c, the MFCs 252a, 252b and 252c and the valves 253a, 253b, 253c and 243a. The first gas supplier 230 may further include the main first gas supply source 250a, the subsidiary first gas supply source 250b and the inert gas supply source 250c.

### <Exhauster 228>

A gas exhaust port 235 through which the gas in the process chamber 201 is exhausted is provided on a side wall of the lower vessel 211. An upstream end of a gas exhaust pipe 231 is connected to the gas exhaust port 235. An APC (Automatic Pressure Controller) valve 242 serving as a pressure regulator (that is, a pressure adjusting structure), a valve 243b serving as an opening/closing valve and a vacuum pump 246 serving as a vacuum exhaust apparatus are sequentially provided at the gas exhaust pipe 231 in this order from an upstream side to a downstream side of the gas exhaust pipe 231 in the gas flow direction.

An exhauster (that is, an exhaust system) 228 according to the present embodiments is constituted mainly by the gas exhaust port 235, the gas exhaust pipe 231, the APC valve 242 and the valve 243b. The exhauster 228 may further include the vacuum pump 246.

### <First Plasma Generator 216>

As shown in FIG. 1, a first plasma generator (which is a first plasma generating structure) 216 is mainly provided on an outside of an outer wall of the upper vessel 210. Specifically, the first electrode 212 serving as a spiral resonance coil is installed on an outer periphery of the process chamber 201 (that is, on an outside of a side wall of the upper vessel 210) so as to surround the process chamber 201. In other words, the first electrode 212 of a spiral shape is provided so as to surround the process vessel 203 outside the upper vessel 210 along a radial direction of the upper vessel 210 (that is, away from a center of the upper vessel 210).

In addition, a first RF (Radio Frequency) sensor 272, a first high frequency power supply 273 and a first matcher (which is a first matching structure) 274 configured to match an impedance and an output frequency of the first high frequency power supply 273 are connected to the first electrode 212.

The first high frequency power supply 273 is configured to supply a first high frequency power (that is, a first RF power) to the first electrode 212. The first RF sensor 272 is provided at an output side of the first high frequency power supply 273, and is configured to monitor information of a traveling wave or reflected wave of the first high frequency power supplied from the first high frequency power supply 273. The information of the reflected wave monitored by the first RF sensor 272 is input to the first matcher 274. Based on the information of the reflected wave, the first matcher 274 is configured to control the impedance of the first high frequency power supply 273 or an output frequency of the first high frequency power so as to minimize an amplitude of the reflected wave.

The first high frequency power supply 273 may include a power supply controller (that is, a control circuit) (not shown) and an amplifier (that is, an output circuit) (not shown). The power supply controller may include a high frequency oscillation circuit (not shown) and a preamplifier (not shown), in order to regulate an oscillation frequency and an output. The amplifier amplifies the output to a predetermined output level. The power supply controller controls the amplifier based on output conditions relating to its frequency and its power, which are set in advance through an operation panel (not shown). A controller 221 serving as a control structure described later is configured to be capable of controlling an output of the first high frequency power using the power supply controller. The amplifier is configured to supply a constant high frequency power to the first electrode 212 via a transmission line.

A winding diameter, a winding pitch and the number of winding turns of the first electrode 212 are set such that the first electrode 212 resonates at a constant wavelength to form a standing wave of a predetermined wavelength. That is, an electrical length of the first electrode 212 is set to a length corresponding to an integral multiple (1 time, 2 times, or so on) of a wavelength of a predetermined frequency of the first high frequency power supplied from the first high frequency power supply 273. In other words, the substrate processing apparatus 100 is provided with the first high frequency power supply 273 such that the first high frequency power can be supplied to the first electrode 212 whose electrical length is the integral multiple of the wavelength of the predetermined frequency of the first high frequency power.

For example, as a material constituting the first electrode 212, a copper pipe, a copper thin plate, an aluminum pipe, an aluminum thin plate, or a material obtained by depositing copper or aluminum on a polymer belt may be used.

Both ends of the first electrode 212 are electrically grounded. At least one end of the first electrode 212 is grounded via a movable tap 213 in order to fine-tune the electrical length of the first electrode 212 when the substrate processing apparatus 100 is newly installed or process conditions of the substrate processing apparatus 100 are changed. A reference numeral 214 shown in FIG. 1 indicates a fixed ground at the other end of the first electrode 212. In addition, a power feeder (not shown) constituted by a movable tap 215 is provided between the grounded both ends of the first electrode 212 in order to fine-tune the impedance of the first electrode 212 when the substrate processing apparatus 100 is newly installed or the process conditions of the substrate processing apparatus 100 are changed.

The first plasma generator 216 according to the present embodiments is constituted mainly by the first electrode 212, the first RF sensor 272 and the first matcher 274. The first plasma generator 216 may further include the first high frequency power supply 273.

### <Shield Plate 223>

As shown in FIG. 1, for example, a shield plate 223 is provided to cover the first electrode 212 outside the process vessel 203 along a radial direction of the process vessel 203 and to shield (or block) an electromagnetic field generated by the first electrode 212. In addition, the shield plate 223 is provided to form a capacitive component (also referred to as a "C component") of the first electrode 212 for constructing a resonance circuit between the shield plate 223 and the first electrode 212. The C component serves as a part of components of the resonance circuit.

Specifically, the shield plate 223 is formed using a conductive material such as an aluminum alloy. A lower flange 227 extending inward along a radial direction of a vessel (that is, the process vessel 203) is provided at a lower end of the shield plate 223 such that the lower flange 227 is placed (or installed) on the base plate 248.

### <Second Plasma Generator 292>

As shown in FIG. 1, a plurality of second plasma generators (which are second plasma generating structures) 292 are respectively arranged (installed) at a plurality of locations (for example, four locations according to the present embodiments) around an outer periphery of the lower end of the shield plate 223. Hereinafter, each of the plurality of second plasma generators 292 may also be referred to as a "second plasma generator 292". Specifically, a second plasma supply structure 282 of an annular shape (see FIG. 2) is installed around an outer periphery of the process vessel 203 so as to surround a portion corresponding to the substrate processing region 201b of the process chamber 201. A plurality of second plasma supply holes 283 (see FIG. 2) are respectively provided at a plurality of locations (for example, twelve locations according to the present embodiments) along a circumferential direction on an inner periphery of the second plasma supply structure 282. Similarly, a plurality of second plasma introduction holes 284 are provided at a plurality of locations (for example, twelve locations according to the present embodiments) along the circumferential direction at a portion of the process vessel 203 corresponding to the substrate processing region 201b. The second plasma supply holes 283 and the second plasma introduction holes 284 are provided at the same positions when viewed from above. In other words, the second plasma supply structure 282 and the process vessel 203 are connected via the second plasma supply holes 283 and the second plasma introduction holes 284.

A plurality of second plasma supply pipes 281 connecting the second plasma generators 292 and the second plasma supply structure 282 are respectively installed at a plurality of locations (for example, four locations according to the present embodiments) around an outer periphery of the second plasma supply structure 282 (see FIG. 2). Hereinafter, each of the plurality of second plasma supply pipes 281 may also be referred to as a "second plasma supply pipe 281". A connection location (connection position) between the second plasma supply pipe 281 and the second plasma supply structure 282 and a connection location (connection position) between the second plasma supply structure 282 and the process vessel 203 do not coincide with each other when viewed from above, as shown in FIG. 2. A second plasma generated in a second plasma generation region (also referred to as a "second plasma generation area") 290 is supplied into the process vessel 203 through the second plasma supply pipes 281.

A second plasma vessel 280 (in which the second plasma generation region 290 where the second plasma is generated is provided) is located outside the second plasma supply pipe 281. A second electrode 285 serving as a spiral resonance coil is provided around an outside of the second plasma vessel 280. In other words, the second electrode 285 of a spiral shape is provided so as to surround an outer periphery of the second plasma vessel 280.

In addition, a second RF (Radio Frequency) sensor 287, a second high frequency power supply 288 and a second matcher (which is a second matching structure) 289 configured to match an impedance and an output frequency of the second high frequency power supply 288 are connected to the second electrode 285.

The second high frequency power supply 288 is configured to supply a second high frequency power (that is, a second RF power) to the second electrode 285. The second RF sensor 287 is provided at an output side of the second high frequency power supply 288, and is configured to monitor information of a traveling wave or reflected wave of the second high frequency power supplied from the second high frequency power supply 288. The information of the reflected wave monitored by the second RF sensor 287 is input to the second matcher 289. Based on the information of the reflected wave, the second matcher 289 is configured to control the impedance of the second high frequency power supply 288 or an output frequency of the second high frequency power so as to minimize an amplitude of the reflected wave.

The second high frequency power supply 288 may include a power supply controller (that is, a control circuit) (not shown) and an amplifier (that is, an output circuit) (not shown). The power supply controller may include a high frequency oscillation circuit (not shown) and a preamplifier (not shown), in order to regulate an oscillation frequency and an output. The amplifier amplifies the output to a predetermined output level. The power supply controller controls the amplifier based on output conditions relating to its frequency and its power, which are set in advance through the operation panel (not shown). The controller 221 serving as the control structure described later is configured to be capable of controlling an output of the second high frequency power using the power supply controller. The amplifier is configured to supply a constant high frequency power to the second electrode 285 via a transmission line.

A winding diameter, a winding pitch and the number of winding turns of the second electrode 285 are set such that the second electrode 285 resonates at a constant wavelength to form a standing wave of a predetermined wavelength. That is, an electrical length of the second electrode 285 is set to a length corresponding to an integral multiple (1 time, 2 times, or so on) of a wavelength of a predetermined frequency of the second high frequency power supplied from the second high frequency power supply 288. In other words, the substrate processing apparatus 100 is provided with the second high frequency power supply 288 such that the second high frequency power can be supplied to the second electrode 285 whose electrical length is the integral multiple of the wavelength of the predetermined frequency of the second high frequency power.

For example, as a material constituting the second electrode 285, a copper pipe, a copper thin plate, an aluminum pipe, an aluminum thin plate, or a material obtained by depositing copper or aluminum on a polymer belt may be used.

Both ends of the second electrode 285 are electrically grounded. A reference numeral 286 shown in FIG. 1 indicates a fixed ground of the second electrode 285.

The second plasma generator 292 according to the present embodiments is constituted mainly by the second electrode 285, the second RF sensor 287 and the second matcher 289. The second plasma generator 292 may further include the second high frequency power supply 288.

A second gas supply pipe 232d is connected to the second plasma generation region 290 of the second plasma vessel 280. An MFC 252d serving as a flow rate controller and a valve 253d serving as an opening/closing valve are sequentially provided at the second gas supply pipe 232d in this order from an upstream side to a downstream side of the second gas supply pipe 232d in the gas flow direction. Although not included in the substrate processing apparatus 100, a second gas supply source 250d is provided at the second gas supply pipe 232d at an upstream side of the MFC 252d.

A second gas supplier (which is a second gas supply system) 239 serving as a part of the gas supplier according to the present embodiments is constituted mainly by the second gas supply pipe 232d, the MFC 252d and the valve 253d. The second gas supplier 239 may further include the second gas supply source 250d.

### <Controller 221>

As shown in FIG.1, the controller 221 serving as the control structure is configured to be capable of respectively controlling: the APC valve 242, the valve 243b and the vacuum pump 246 through a signal line "A"; the susceptor elevator 268 through a signal line "B"; and the heater power regulator 276 and the variable impedance regulator 275 through a signal line "C". In addition, the controller 221 is further configured to be capable of respectively controlling: the gate valve 244 through a signal line "D"; the RF sensors 272 and 287, the high frequency power supplies 273 and 288, the matchers 274 and 289 through a signal line "E"; and the MFCs 252a to 252d and the valves 253a to 253d and 243a through a signal line "F".

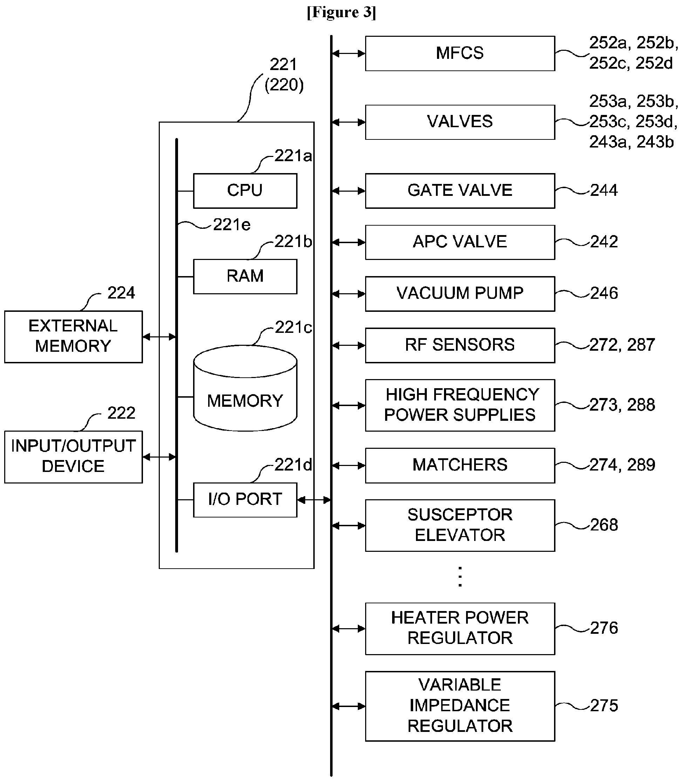

As shown in FIG. 3, the controller 221 is constituted by a computer 220 including a CPU (Central Processing Unit) 221a, a RAM (Random Access Memory) 221b, a memory 221c and an I/O port (input/output port) 221d. The RAM 221b, the memory 221c and the I/O port 221d are configured to be capable of exchanging data with the CPU 221a through an internal bus 221e. For example, an input/output device 222 (which is constituted by components such as a touch panel and a display) is connected to the controller 221.

According to the present embodiments, the input/output device 222 is configured to receive an input such as process conditions for processing the wafer 200 and an operation command for executing a substrate processing described later. In addition, the input/output device 222 is further configured to display a state of the substrate processing apparatus 100.

The memory 221c may be embodied by a component such as a flash memory and a hard disk drive (HDD). For example, a control program configured to control operations of the substrate processing apparatus 100, a process recipe in which information such as procedures and conditions of the substrate processing described later is stored, and a recipe execution program configured to execute the process recipe may be readably stored in the memory 221c.

The recipe execution program is obtained by combining steps (procedures) of the substrate processing described later such that the CPU 221a can execute the steps to acquire a predetermined result, and functions as a program. Hereinafter, the recipe execution program and the control program may be collectively or individually referred to as a "program" (that is, a program product). Thus, in the present specification, the term "program" may refer to the recipe execution program alone, may refer to the control program alone, or may refer to both of the recipe execution program and the control program. In addition, the RAM 221b functions as a memory area (that is, a work area) where a program or data read by the CPU 221a is temporarily stored.

According to the present embodiments, each process condition is stored in the memory 221c. The process conditions include at least one among the following: a temperature of the wafer 200 to be processed, a pressure (inner pressure) of the process chamber 201, a type of gas used to process the wafer 200, a flow rate of the gas used to process the wafer 200 and electric powers supplied to the first electrode 212 and the second electrode 285.

The I/O port 221d is electrically connected to the components described above such as the MFCs 252a to 252d, the valves 253a to 253d, 243a and 243b, the gate valve 244, the APC valve 242, the vacuum pump 246, the RF sensors 272 and 287, the high frequency power supplies 273 and 288, the matchers 274 and 289, the susceptor elevator 268, the heater power regulator 276 and the variable impedance regulator 275.

The CPU 221a is configured to read and execute the control program stored in the memory 221c, and to read the process recipe stored in the memory 221c in accordance with an instruction such as an operation command inputted via the input/output device 222.

In accordance with the process recipe read from the memory 221c, the CPU 221a is further configured to be capable of controlling operations such as an operation of adjusting an opening degree of the APC valve 242, an opening and closing operation of the valve 243b and a start and stop of the vacuum pump 246 via the I/O port 221d and the signal line "A". The CPU 221a is further configured to be capable of controlling operations such as an elevating and lowering operation of the susceptor elevator 268 via the I/O port 221d and the signal line "B", a power supply amount adjusting operation (that is, a temperature adjusting operation) to the heater 217b by the heater power regulator 276 and the variable impedance regulator 275 via the I/O port 221d and the signal line "C", and an opening and closing operation of the gate valve 244 via the I/O port 221d and the signal line "D". The CPU 221a is further configured to be capable of controlling operations such as operations of the first RF sensor 272, the first matcher 274 and the first high frequency power supply 273 related to the first electrode 212 and operations of the second RF sensor 287, the second matcher 289 and the second high frequency power supply 288 related to the second electrode 285 via the I/O port 221d and the signal line "E". The CPU 221a is further configured to be capable of controlling operations such as flow rate adjusting operations for various gases (including the first gas) by the MFCs 252a to 252c for generating the first plasma, opening and closing operations of the valves 253a to 253c and 243a, a flow rate adjusting operation for the second gas by the MFC 252d for generating the second plasma and an opening and closing operation of the valve 253d via the I/O port 221d and the signal line "F". Thereby, the controller 221 serving as the control structure is configured to be capable of controlling each of the first plasma generation region 201a for generating the first plasma and the second plasma generation region 290 for generating the second plasma.

As described above, the substrate processing apparatus 100 according to the present embodiments may include:
the process vessel 203 provided with: the first plasma generation region 201a where at least one first gas is supplied to generate the first plasma from the at least one first gas; and the substrate processing region 201b where the wafer 200 serving as the substrate is plasma-processed;
the first plasma generator 216 provided with the first electrode 212 arranged (or installed) on the outer periphery of the process vessel 203 and configured to generate the first plasma in the first plasma generation region 201a when the first high frequency power is supplied;
the mounting structure provided with the susceptor 217 on which the wafer 200 (substrate) is placed, wherein the susceptor 217 is arranged at the lower portion of the process vessel 203;
the second plasma generator 292 provided with: the second plasma generation region 290 where the second gas is supplied to generate the second plasma from the second gas; and the second electrode 285 configured to generate the second plasma in the second plasma generation region 290 when the second high frequency power is supplied, wherein the second plasma generator 292 is configured to supply the second plasma into the process vessel 203 from a side surface of the process vessel 203; and
the controller 221 configured to be capable of controlling each of the first plasma generator 216 and the second plasma generator 292.

With such a configuration, by supplying the second plasma from the side surface of the process vessel 203 to the first plasma generated in the process vessel 203, it is possible to control characteristics (such as an electron density, a plasma potential and an electron temperature) on the wafer 200 (substrate). Thereby, it is possible to improve a coverage performance on the wafer 200 (substrate).

As shown in FIG. 1, the substrate processing apparatus 100 according to the present embodiments is configured such that the second plasma generated in the second plasma generation region 290 is supplied between the first plasma generation region 201a and the mounting structure (that is, the susceptor 217). The substrate processing apparatus 100 is further configured such that the second plasma is supplied to the substrate processing region 201b. The substrate processing apparatus 100 is further configured such that the second plasma is supplied immediately above the substrate (that is, the wafer 200) placed on the mounting structure. With such a configuration, in addition to the first plasma generated in the first plasma generation region 201a, the second plasma is further supplied above the substrate (that is, the wafer 200) placed on the mounting structure (that is, the susceptor 217). Thereby, it is possible to activate radicals immediately above the substrate (that is, the wafer 200).

The substrate processing apparatus 100 according to the present embodiments is provided with the second plasma supply pipe 281 connecting the second plasma generation region 290 with an inside (inner portion) of the process vessel 203. Thereby, the second plasma generated in the second plasma generation region 290 is supplied into the process vessel 203 through the second plasma supply pipe 281. With such a configuration, even when the second plasma is generated at a location away from the process vessel 203, it is possible to supply the second plasma generated as described above into the process vessel 203.

As shown in FIG. 2, the substrate processing apparatus 100 according to the present embodiments is configured such that the second plasma supplied through the second plasma supply pipe 281 is supplied in a horizontal direction to the substrate (that is, the wafer 200) placed on the mounting structure (that is, the susceptor 217). With such a configuration, it is possible to supply the second plasma toward a center of the substrate (that is, the wafer 200), and it is also possible to improve a uniformity of the substrate (that is, the wafer 200) on a surface thereof.

As shown in FIG. 2, the substrate processing apparatus 100 is further configured such that the second plasma supplied through the second plasma supply pipe 281 is further supplied into the process vessel 203 through the plurality of second plasma supply holes 283 of the second plasma supply structure 282 arranged in an outer circumferential direction of the process vessel 203. With such a configuration, it is possible to more uniformly supply the plasma (such as the second plasma) toward a center of the process vessel 203 through the plurality of second plasma supply holes 283.

As shown in FIG. 2, the substrate processing apparatus 100 is further configured such that the second plasma supplied through the second plasma supply pipe 281 is further supplied toward a central portion in the process vessel 203 through the plurality of second plasma supply holes 283. With such a configuration, by supplying the second plasma toward the center of the process vessel 203 to the first plasma supplied to the substrate (that is, the wafer 200) along an inner periphery of the process vessel 203, it is possible to supply the second plasma so as to push the first plasma toward the center of the substrate (that is, the wafer 200), and it is also possible to improve the uniformity of the substrate (that is, the wafer 200) on the surface thereof.

As shown in FIGS. 1 and 2, the substrate processing apparatus 100 is further configured such that the process vessel 203 is provided with the second plasma introduction holes 284 through which the second plasma supplied as described above is introduced and such that the second plasma supply holes 283 face the second plasma introduction holes 284, respectively. With such a configuration, by arranging the second plasma supply holes 283 and the second plasma introduction holes 284 at the same location (position), it is possible to introduce the second plasma generated as described above into the process vessel 203 while minimizing a deactivation of the second plasma.

As shown in FIG. 2, the substrate processing apparatus 100 is further configured such that the plurality of second plasma generators 292 are installed and such that the second plasma generators 292 are arranged in the outer circumferential direction of the process vessel 203. The substrate processing apparatus 100 is further configured such that the second plasma supplied from the second plasma generators 292 is distributed (or dispersed) along the outer periphery of the process vessel 203. By providing the second plasma generators 292 in a manner described above, it is possible to easily and uniformly supply the second plasma into the process vessel 203.

In the substrate processing apparatus 100 according to the present embodiments, it is preferable that the controller 221 is configured to be capable of independently controlling the output of the first high frequency power and the output of the second high frequency power. With such a configuration, it is possible to generate the plasma more accurately.

In the substrate processing apparatus 100 according to the present embodiments, it is preferable that the controller 221 is configured to be capable of controlling a supply timing of the first gas and a supply timing of the second gas. With such a configuration, it is possible to control a generation of the plasma more precisely.

According to the present embodiments, the second plasma is merely secondary. That is, the second plasma is supplied to activate the first plasma and to adjust a flow of the first plasma. Therefore, in the substrate processing apparatus 100 according to the present embodiments, it is preferable that the controller 221 is configured to be capable of controlling a supply amount of the second gas to be less than a supply amount of the first gas.

In the substrate processing apparatus 100 according to the present embodiments, it is preferable that the controller 221 is configured to be capable of controlling a frequency of the first high frequency power and a frequency of the second high frequency power to synchronize (or match) a phase of the frequency of the first high frequency power and a phase of the frequency of the second high frequency power. With such a configuration, it is possible to synchronize (or match) a generation timing of the first plasma and a generation timing of the second plasma.

### (2) Substrate Processing Method and Method of Manufacturing Semiconductor Device

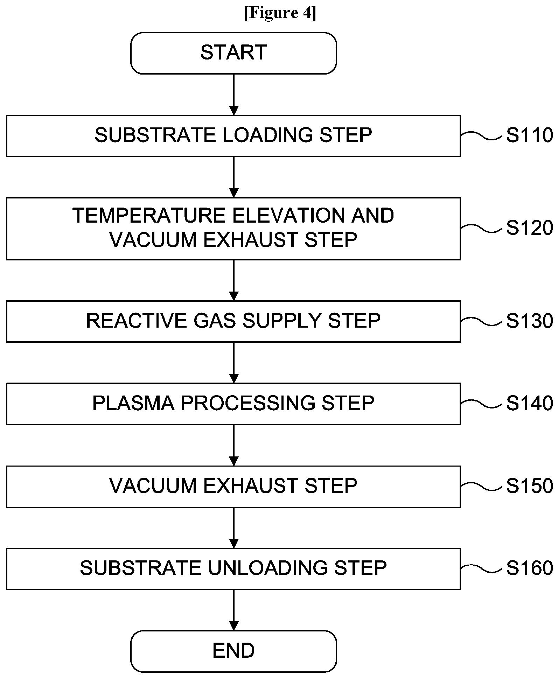

Hereinafter, an exemplary process sequence of the substrate processing (film-forming process) of forming a film containing a predetermined element on the wafer 200 serving as the substrate will be described with reference to FIG. 4. The substrate processing serves as a part of a manufacturing process of a semiconductor device, and is performed by using the substrate processing apparatus 100 described above. In the following descriptions, operations of components constituting the substrate processing apparatus 100 are controlled by the controller 221.

### <Step of Adjusting Inner Pressure of Process chamber 201>

First, before starting the substrate processing, the inner pressure of the process chamber 201 (which is adjusted to an atmospheric pressure) is adjusted to the same pressure as a vacuum transfer chamber (not shown) provided adjacent to the process chamber 201 by adjusting the opening degree of the APC valve 242. Then, the following steps S110 to S160 are performed.

### <Substrate Loading Step S110>

In the substrate loading step S110, the wafer 200 is transferred (loaded) into the process chamber 201. Specifically, the susceptor 217 is lowered to a transfer position of the wafer 200 by the susceptor elevator 268 such that the wafer lift pins 266 pass through the through-holes 217a of the susceptor 217.

Subsequently, the gate valve 244 is opened, and the wafer 200 is loaded into the process chamber 201 using the wafer transfer structure (not shown) from the vacuum transfer chamber (not shown) provided adjacent to the process chamber 201. The wafer 200 loaded into the process chamber 201 is placed on and supported by the wafer lift pins 266 (which protrude from a surface of the susceptor 217) in a horizontal orientation. After the wafer 200 is loaded into the process chamber 201, the wafer transfer structure is retracted to a position outside the process chamber 201, and the gate valve 244 is closed to hermetically seal (or close) the process chamber 201. Thereafter, by elevating the susceptor 217 using the susceptor elevator 268, the wafer 200 is placed on and supported by an upper surface of the susceptor 217.

### <Temperature Elevation and Vacuum Exhaust Step S120>

In the temperature elevation and vacuum exhaust step S120, the temperature of the wafer 200 loaded into the process chamber 201 is elevated. The heater 217b is heated in advance, and the wafer 200 is heated by placing the wafer 200 on the susceptor 217 where the heater 217b is embedded. In the present step, the wafer 200 is heated such that the temperature of the wafer 200 reaches and is maintained at a target temperature. In addition, while the temperature of the wafer 200 is being elevated, the vacuum pump 246 vacuum-exhausts the process chamber 201 through the gas exhaust pipe 231 such that the inner pressure of the process chamber 201 reaches and is maintained at a predetermined pressure. The vacuum pump 246 is continuously operated at least until the substrate unloading step S160 described later is completed.

### <Reactive Gas Supply Step S130>

In the reactive gas supply step S130, as a supply of a reactive gas, the supply of the first gas (that is, a supply of the main first gas and a supply of the subsidiary first gas) into the process chamber 201 is started. Specifically, the valve 253a and the valve 253b are opened to start the supply of the main first gas and the supply of the subsidiary first gas into the process chamber 201 while flow rates of the main first gas and the subsidiary first gas are adjusted by the MFCs 252a and 252b, respectively.

In addition, an exhaust of the process chamber 201 is controlled by adjusting the opening degree of the APC valve 242 such that the inner pressure of the process chamber 201 reaches and is maintained at a target pressure. While appropriately exhausting the process chamber 201 in a manner described above, the main first gas and the subsidiary first gas are continuously supplied into the process chamber 201 until the plasma processing step S140 described later is completed.

As the main first gas, for example, an oxygen-containing gas may be used. As the oxygen-containing gas, for example, a gas such as oxygen (O₂) gas may be used.

As the subsidiary first gas, for example, a hydrogen-containing gas may be used. As the hydrogen-containing gas, for example, a gas such as hydrogen (H₂) gas may be used.

Similarly, in the reactive gas supply process S130, the supply of the second gas is also started. Specifically, the valve 253d is opened to start the supply of the second gas to the second plasma generation region 290 while a flow rate of the second gas is adjusted by the MFC 252d.

A pressure (inner pressure) of the second plasma generation region 290 follows a pressure control of the process chamber 201 which is connected to the second plasma generation region 290 via the second plasma supply pipe 281 and the second plasma supply structure 282. Then, the second gas is supplied continuously until the plasma processing step S140 described later is completed.

In the present step, it is preferable that the second gas supplied to the second plasma generation region 290 contains a part of the first gas (for example, one of the main first gas and the subsidiary first gas). By setting the second gas for generating the second plasma to be the same as the first gas (that is, the same as a part of the first gas), it is possible to activate the first plasma (which is generated in the process vessel 203) by the second plasma. As the second gas, for example, an oxygen-containing gas may be used. As the oxygen-containing gas, for example, a gas such as the oxygen (O₂) gas (which is the same as the main first gas of the first gas) may be used.

### <Plasma Processing Step S140>

After the inner pressure of the process chamber 201 is stabilized, in the plasma processing step S140, a supply (application) of the first high frequency power to the first electrode 212 from the first high frequency power supply 273 via the first RF sensor 272 is started. Simultaneously, a supply (application) of the second high frequency power to the second electrode 285 from the second high frequency power supply 288 via the second RF sensor 287 is started.

Thereby, a high frequency electric field is formed (or provided) in the first plasma generation region 201a to which the first gas is supplied. By such an electric field, the first plasma (that is, a donut-shaped induction plasma) whose plasma density is the highest at a height position corresponding to an electrical midpoint of the first electrode 212 in the first plasma generation region 201a can be excited. The first gas is excited into a plasma state and dissociates. As a result, reactive species such as radicals (that is, active species) and ions of elements contained in the first gas can be generated. Specifically, reactive species such as oxygen radicals (that is, oxygen active species) and oxygen ions containing oxygen, hydrogen radicals (that is, hydrogen active species) and hydrogen ions containing hydrogen are generated.

Simultaneously, a high frequency electric field is formed (or provided) in the second plasma generation region 290 to which the second gas is supplied. By such an electric field, the second plasma (that is, a donut-shaped induction plasma) whose plasma density is the highest at a height position corresponding to an electrical midpoint of the second electrode 285 in the second plasma generation region 290 can be excited. The second gas is excited into a plasma state and dissociates. As a result, reactive species such as radicals (that is, active species) and ions of elements contained in the second gas can be generated. Specifically, reactive species such as oxygen radicals (that is, oxygen active species) and oxygen ions containing oxygen are generated.

Then, the radicals and the ions generated by the induction plasma are supplied into a trench on the surface of the wafer 200 placed on the susceptor 217 in the substrate processing region 201b. Then, the radicals and the ions supplied into the trench react with a side wall of the trench. Thereby, a surface layer of the trench is modified. Specifically, for example, a silicon layer on a surface of the trench is modified into a silicon oxide layer. In such an operation, the second plasma generated in the second plasma generation region 290, together with the second gas whose flow rate is adjusted by the MFC 252d, flows through the second plasma supply pipe 281 and the second plasma supply structure 282, passes through the second plasma supply holes 283 and the second plasma introduction holes 284, and enters the substrate processing region 201b in the process vessel 203 such that the second plasma is supplied so as to push the first plasma toward the center of the wafer 200.

Then, after a predetermined process time has elapsed, the supply of the first high frequency power from the first high frequency power supply 273 is stopped to stop a plasma discharge in the process chamber 201. Simultaneously, the supply of the second high frequency power from the second high frequency power supply 288 is also stopped to stop a plasma discharge in the second plasma generation region 290. In addition, the valve 253a and the valve 253b are closed to stop the supply of the main first gas and the supply of the subsidiary first gas into the process chamber 201. Simultaneously, the valve 253d is closed to stop the supply of the second gas into the second plasma generation region 290. Thereby, the plasma processing step S140 is completed.

### <Vacuum Exhaust Step S150>

After the supply of the first gas and the supply of the second gas are stopped, in the vacuum exhaust step S150, an atmosphere (inner atmosphere) of the process chamber 201 is vacuum-exhausted through the gas exhaust pipe 231. Thereby, a gas such as the first gas, the second gas and an exhaust gas generated from a reaction therebetween in the process chamber 201 can be exhausted out of the process chamber 201. Thereafter, the opening degree of the APC valve 242 is adjusted such that the inner pressure of the process chamber 201 is adjusted to the same pressure as that of the vacuum transfer chamber (to which the wafer 200 is to be transferred: not shown) provided adjacent to the process chamber 201.

### <Substrate Unloading Step S160>

After the inner pressure of the process chamber 201 is adjusted to a predetermined pressure, in the substrate unloading step S160, the susceptor 217 is lowered to the transfer position of the wafer 200 until the wafer 200 is supported by the wafer lift pins 266. Then, the gate valve 244 is opened, and the wafer 200 is transferred (unloaded) out of the process chamber 201 by using the wafer transfer structure (not shown). Thereby, the substrate processing according to the present embodiments is completed.

### <Maintenance Step>

After the substrate processing is performed a plurality of times, a maintenance operation is performed on the substrate processing apparatus 100. In such an operation, the opening degree of the APC valve 242 is adjusted such that the inner pressure of the process chamber 201 is adjusted to the atmospheric pressure.

### <Substrate Processing Method>

As described above, a substrate processing method according to the present embodiments may include:
(a) placing the wafer 200 serving as the substrate on the mounting structure provided with the susceptor 217 arranged at the lower portion of the process vessel 203, wherein the process vessel 203 is provided with the first plasma generation region 201a where the first plasma is generated and the substrate processing region 201b where the wafer 200 serving as the substrate is plasma-processed;
(b) supplying at least one first gas into the process vessel 203;
(c) generating the first plasma in the first plasma generation region 201a using the first electrode 212 arranged (or installed) on the outer periphery of the process vessel 203;
(d) supplying the second gas to the second plasma generation region 290 where the second plasma is generated; and
(e) supplying the second plasma into the process vessel 203 from the side surface of the process vessel 203.

With such a configuration, by supplying the second plasma from the side surface of the process vessel 203 to the first plasma generated in the process vessel 203, it is possible to control the characteristics (such as the electron density, the plasma potential and the electron temperature) on the wafer 200 (substrate). Thereby, it is possible to improve the coverage performance on the wafer 200 (substrate).

### <Method of Manufacturing Semiconductor Device>

As described above, a method of manufacturing the semiconductor device according to the present embodiments may include:
(a) placing the wafer 200 serving as the substrate on the mounting structure provided with the susceptor 217 arranged at the lower portion of the process vessel 203, wherein the process vessel 203 is provided with the first plasma generation region 201a where the first plasma is generated and the substrate processing region 201b where the wafer 200 serving as the substrate is plasma-processed;
(b) supplying at least one first gas into the process vessel 203;
(c) generating the first plasma in the first plasma generation region 201a using the first electrode 212 arranged (or installed) on the outer periphery of the process vessel 203;
(d) supplying the second gas to the second plasma generation region 290 where the second plasma is generated; and
(e) supplying the second plasma into the process vessel 203 from the side surface of the process vessel 203.

With such a configuration, by supplying the second plasma from the side surface of the process vessel 203 to the first plasma generated in the process vessel 203, it is possible to control the characteristics (such as the electron density, the plasma potential and the electron temperature) on the wafer 200 (substrate). Thereby, it is possible to improve the coverage performance on the wafer 200 (substrate).

### (3) Program

The controller 221 may be configured by installing the above-mentioned program stored in an external memory 224 (for example, a magnetic tape, a magnetic disk such as a flexible disk and a hard disk, an optical disk such as a CD and a DVD, a magneto-optical disk such as an MO and a semiconductor memory such as a USB memory and a memory card) into the computer 220. The memory 221c or the external memory 224 may be embodied by a non-transitory computer readable recording medium. Hereafter, the memory 221c and the external memory 224 may be collectively or individually referred to as a "recording medium". Thus, in the present specification, the term "recording medium" may refer to the memory 221c alone, may refer to the external memory 224 alone, or may refer to both of the memory 221c and the external memory 224. The program may be provided to the computer 220 without using the external memory 224. For example, the program may be supplied to the computer 220 using a communication interface such as the Internet and a dedicated line via an external communication interface (not shown). For example, the program provided by using the communication interface such as the Internet and the dedicated line may be stored in the recording medium, and then the program stored in the recording medium may be used.

The program according to the present embodiments may cause the substrate processing apparatus 100, by the computer 200, to perform:
(a) placing the wafer 200 serving as the substrate on the mounting structure provided with the susceptor 217 arranged at the lower portion of the process vessel 203, wherein the process vessel 203 is provided with the first plasma generation region 201a where the first plasma is generated and the substrate processing region 201b where the wafer 200 serving as the substrate is plasma-processed;
(b) supplying at least one first gas into the process vessel 203;
(c) generating the first plasma in the first plasma generation region 201a using the first electrode 212 arranged (or installed) on the outer periphery of the process vessel 203;
(d) supplying the second gas to the second plasma generation region 290 where the second plasma is generated; and
(e) supplying the second plasma into the process vessel 203 from the side surface of the process vessel 203.

With such a configuration, by supplying the second plasma from the side surface of the process vessel 203 to the first plasma generated in the process vessel 203, it is possible to control the characteristics (such as the electron density, the plasma potential and the electron temperature) on the wafer 200 (substrate). Thereby, it is possible to improve the coverage performance on the wafer 200 (substrate). The program may be stored in the recording medium mentioned above, and then the program stored in the recording medium may be used.

The present invention may be summarized as follows: It is possible to uniformly distribute a plasma on a substrate being processed in a process chamber. There is provided a technique that includes: a process vessel including: a first plasma generation region where a first gas is supplied to generate a first plasma; and a substrate processing region; a first plasma generator including a first electrode on an outer periphery of the process vessel to generate the first plasma by a first high frequency power; a substrate mounting structure at the process vessel; a second plasma generator including: a second plasma generation region where a second gas is supplied to generate a second plasma; and a second electrode for generating the second plasma by a second high frequency, wherein the second plasma generator supplies the second plasma into the process vessel from beside the process vessel; and a controller for controlling the first and the second plasma generator.

### <Other Embodiments>

While the technique of the present disclosure is described in detail by way of the embodiments mentioned above, the technique of the present disclosure is not limited thereto. It will be apparent to those skilled in the art that the technique of the present disclosure may be modified in various ways without departing from the scope thereof. Even in such a case, it is possible to obtain one or more of the effects mentioned above.

In addition, although not specifically described in the embodiments mentioned above, the number of each component described in the present specification is not limited to one, and the number of each component may be two or more unless otherwise specified in the present specification.

For example, the embodiments mentioned above are described by way of an example in which a single wafer type substrate processing apparatus capable of processing one or several substrates at once is used to form the film. However, the technique of the present disclosure is not limited thereto. For example, the technique of the present disclosure may be preferably applied when a batch type substrate processing apparatus capable of simultaneously processing a plurality of substrates is used to form the film. For example, the embodiments mentioned above are described by way of an example in which a substrate processing apparatus including a cold wall type process furnace is used to form the film. However, the technique of the present disclosure is not limited thereto. For example, the technique of the present disclosure may be preferably applied when a substrate processing apparatus including a hot wall type process furnace is used to form the film.

The process procedures and the process conditions of each process using the substrate processing apparatuses exemplified above may be substantially the same as those of the embodiments or modified examples mentioned above. Even in such a case, it is possible to obtain substantially the same effects as in the embodiments or the modified examples mentioned above.

In addition, the embodiments and the modified examples mentioned above may be appropriately combined. The process procedures and the process conditions of each combination thereof may be substantially the same as those of the embodiments mentioned above or the modified examples mentioned above.

### [Description of Reference Numerals]

| | | | |
|---|---|---|---|
| 200: | substrate (wafer) | 201a: | first plasma generation region |
| 201b: | substrate processing region | 203: | process vessel |
| 212: | first electrode | 216: | first plasma generator |
| 217: | mounting structure (susceptor) | 221: | control structure (controller) |
| 285: | second electrode | 290: | second plasma generation region |
| 292: | second plasma generator | | |

## Claims

1. A substrate processing apparatus comprising:
a process vessel provided with: a first plasma generation region where at least one first gas is supplied to generate a first plasma from the at least one first gas; and a substrate processing region where a substrate is plasma-processed;
a first plasma generator provided with a first electrode arranged on an outer periphery of the process vessel and configured to generate the first plasma in the first plasma generation region when a first high frequency power is supplied;
a mounting structure arranged at a lower portion of the process vessel and configured such that the substrate is placed on the mounting structure;
a second plasma generator provided with: a second plasma generation region where a second gas is supplied to generate a second plasma from the second gas; and a second electrode configured to generate the second plasma in the second plasma generation region when a second high frequency power is supplied, wherein the second plasma generator is configured to supply the second plasma into the process vessel from a side surface of the process vessel; and
a controller configured to be capable of controlling each of the first plasma generator and the second plasma generator.

2. The substrate processing apparatus of claim 1, wherein the second plasma is supplied between the first plasma generation region and the mounting structure.

3. The substrate processing apparatus of claim 1 and/or 2, wherein the second plasma is supplied to the substrate processing region.

4. The substrate processing apparatus of any one or more of claims 1 to 3, wherein the second plasma is supplied immediately above the substrate.

5. The substrate processing apparatus of any one or more of claims 1 to 4, further comprising:
a second plasma supply pipe connecting the second plasma generation region with an inside of the process vessel,
wherein the second plasma generated in the second plasma generation region is supplied into the process vessel through the second plasma supply pipe.

6. The substrate processing apparatus of claim 5, wherein the second plasma supplied through the second plasma supply pipe is further supplied into the process vessel through a plurality of second plasma supply holes of a second plasma supply structure arranged in an outer circumferential direction of the process vessel.

7. The substrate processing apparatus of any one or more of claims 1 to 6, wherein the second gas supplied to the second plasma generation region contains one of the at least one first gas.

8. The substrate processing apparatus of any one or more of claims 1 to 7, further comprising:
one or more second plasma generators,
wherein the second plasma generator and the one or more second plasma generators are arranged in an outer circumferential direction of the process vessel.

9. The substrate processing apparatus of any one or more of claims 1 to 8, wherein the controller is further configured to be capable of independently controlling an output of the first high frequency power and an output of the second high frequency power.

10. The substrate processing apparatus of any one or more of claims 1 to 9, wherein the controller is further configured to be capable of controlling a supply timing of the at least one first gas and a supply timing of the second gas.

11. The substrate processing apparatus of any one or more of claims 1 to 10, wherein the controller is further configured to be capable of controlling a supply amount of the second gas to be less than a supply amount of the at least one first gas.

12. The substrate processing apparatus of any one or more of claims 1 to 11, wherein the controller is further configured to be capable of controlling a frequency of the first high frequency power and a frequency of the second high frequency power to synchronize a phase of the frequency of the first high frequency power and a phase of the frequency of the second high frequency power.

13. A substrate processing method comprising:
(a) placing a substrate on a mounting structure arranged at a lower portion of a process vessel, wherein the process vessel is provided with a first plasma generation region where a first plasma is generated and a substrate processing region where the substrate is plasma-processed;
(b) supplying at least one first gas into the process vessel;
(c) generating the first plasma in the first plasma generation region using a first electrode arranged on an outer periphery of the process vessel;
(d) supplying a second gas to a second plasma generation region where a second plasma is generated; and
(e) supplying the second plasma into the process vessel from a side surface of the process vessel.

14. A method of manufacturing a semiconductor device, comprising
the method of claim 13.

15. A program that causes a substrate processing apparatus, by a computer, to perform:
(a) placing a substrate on a mounting structure arranged at a lower portion of a process vessel, wherein the process vessel is provided with a first plasma generation region where a first plasma is generated and a substrate processing region where the substrate is plasma-processed;
(b) supplying at least one first gas into the process vessel;
(c) generating the first plasma in the first plasma generation region using a first electrode arranged on an outer periphery of the process vessel;
(d) supplying a second gas to a second plasma generation region where a second plasma is generated; and
(e) supplying the second plasma into the process vessel from a side surface of the process vessel.
